# EUROPEAN PATENT APPLICATION

(11) **EP 4 779 327 A1**
(43) Date of publication of application: **22.07.2026**
(21) Application number: 24879926.4
(22) Date of filing: 21.08.2024
(51) Int. Cl.: G01R 22/06, F25B 49/00, F25D 29/00, F24F 11/00

(54) **INSPECTION APPARATUS AND METHOD FOR CONTROLLING SAME**

(30) Priority: 18.10.2023 KR 20230139919
(71) Applicant: Samsung Electronics Co., Ltd., Suwon-si, Gyeonggi-do 16677 (KR)
(72) Inventor: CHO, Myunghoon, Suwon-si Gyeonggi-do 16677 (KR); LEE, Wonje, Suwon-si Gyeonggi-do 16677 (KR)
(74) Representative: Walaski, Jan Filip
(86) International application number: PCT/KR2024/012421
(87) International publication number: WO 2025/084586

(57) **Abstract**

In a method for controlling an inspection apparatus (1) configured to inspect power consumption of a home appliance including a compressor, the method may include: transmitting a signal for operating the compressor at a preset rotations per minute (RPM) to the home appliance; obtaining a power value detected in the home appliance from the home appliance; and determining whether the home appliance is defective based on power values obtained during a preset time (TP1) among the obtained power values.

## Description

### [Technical Field]

The disclosure relates to an inspection apparatus and a method for controlling the same.

### [Background Art]

Globally, regulations on the power consumption of various home appliances are being strengthened for eco-friendliness and in response to the energy crisis. Accordingly, manufacturers of home appliances conduct extensive research and development to secure power-consumption inspection capabilities for complete products before shipment.

In the case of home appliances using a refrigeration cycle, inspections of each component unit are performed to examine factors influencing the refrigeration cycle, and sampling inspections are frequently conducted due to limitations in inspection facilities and time.

### [Disclosure]

### [Technical Problem]

The disclosure provides an inspection apparatus that may determine whether a home appliance is defective by detecting a power value of the home appliance.

### [Technical Solution]

According to an aspect of the disclosure, in a method for controlling an inspection apparatus 1 configured to inspect power consumption of a home appliance including a compressor, the method may include: transmitting a signal for operating the compressor at a preset rotations per minute (RPM) to the home appliance; obtaining a power value detected in the home appliance from the home appliance; and determining whether the home appliance is defective based on power values obtained during a preset time TP1 among the obtained power values.

According to an aspect of the disclosure, an inspection apparatus 1 may include: communication circuitry 100 configured to communicate with a home appliance; a user interface 200 configured to receive a user input or output information to a user; and a controller 300 configured to perform a power consumption inspection of the home appliance based on the received user input, wherein the controller 300 may be configured to: transmit a signal for operating a compressor included in the home appliance at a preset rotations per minute (RPM) to the home appliance through communication circuitry 100; obtain a power value detected in the home appliance from the home appliance through the communication circuitry 100; and determine whether the home appliance is defective based on a power value corresponding to a preset time TP1 among the obtained power values.

### [Advantageous Effects]

According to an aspect of the disclosure, whether a home appliance is defective and a defective state of the home appliance may be determined within a limited time, thereby enabling efficient power consumption inspection.

According to an aspect of the disclosure, a total inspection may be performed due to the shortened inspection time instead of a sampling inspection, thereby enhancing product competitiveness.

According to an aspect of the disclosure, characteristics of a refrigeration cycle may be maximized by driving a compressor at a highest rotations per minute (RPM), thereby increasing power-consumption inspection capabilities.

According to an aspect of the disclosure, power consumption may be easily inspected in a complete product rather than in component units before shipment of the product.

The effects that may achieved by the disclosure are not limited to the above-mentioned effects, and other effects not mentioned will be clearly understood by one of ordinary skill in the technical art to which the disclosure belongs from the following description.

### [Description of Drawings]

FIG. 1 is a control block diagram of an inspection apparatus 1 according to an embodiment.
FIG. 2 is a flowchart illustrating a method for controlling the inspection apparatus 1 according to an embodiment.
FIG. 3 is a flowchart illustrating a method for controlling the inspection apparatus 1 according to an embodiment.
FIG. 4 is a graph illustrating power values detected in a home appliance over time according to an embodiment.
FIG. 5 is a graph illustrating an average value of power values corresponding to a preset time TP1 for each of a plurality of home appliances to be inspected according to an embodiment.
FIG. 6 is a graph comparing a power value detected in a defective home appliance and a power value detected in a non-defective home appliance according to an embodiment.
FIG. 7 is a graph illustrating an average value of power values corresponding to the preset time TP1 among power values detected in a defective home appliance according to an embodiment.
FIG. 8 is a graph comparing a power value detected in a defective home appliance and a power value detected in a non-defective home appliance according to an embodiment.
FIG. 9 is a graph illustrating an average value of power values corresponding to the preset time TP1 among power values detected in a defective home appliance according to an embodiment.

### [Modes of the Invention]

Embodiments described in the disclosure and configurations shown in the drawings are merely examples of the embodiments of the disclosure, and may be modified in various different ways at the time of filing of the application to replace the embodiments and drawings of the disclosure.

In describing of the drawings, similar reference numerals may be used for similar or related elements.

The singular form of a noun corresponding to an item may include one or more items unless the context states otherwise.

As used herein, each of the expressions "A or B," "at least one of A and B," "at least one of A or B," "A, B, or C," "at least one of A, B, and C," and "at least one of A, B, or C," may include one or all possible combinations of the items listed together with a corresponding expression among the expressions.

The expression "and/or" is interpreted to include a combination or any of associated elements.

For example, "A, B, and/or C," may include one or all possible combinations of the items listed together with a corresponding expression among the expressions.

It will be understood that the terms "first", "second", etc., may be used only to distinguish one component from other components, and are not intended to limit the corresponding component in other aspects (e.g., importance or order).

When an element (e.g., a first element) is referred to as being "(functionally or communicatively) coupled" or "connected" to another element (e.g., a second element), the first element may be connected to the second element, directly (e.g., wired), wirelessly, or through a third element.

It will be understood that when the terms "includes", "comprises", "including", and/or "comprising" are used in the disclosure, they specify the presence of the specified features, figures, steps, operations, components, members, or combinations thereof, but do not preclude the presence or addition of one or more other features, figures, steps, operations, components, members, or combinations thereof.

When a given element is referred to as being "connected to", "coupled to", "supported by" or "in contact with" another element, it is to be understood that it may be directly or indirectly connected to, coupled to, supported by, or in contact with the other element. When a given element is indirectly connected to, coupled to, supported by, or in contact with another element, it is to be understood that it may be connected to, coupled to, supported by, or in contact with the other element through a third element.

It will also be understood that when an element is referred to as being "on" another element, it may be directly on the other element or intervening elements may also be present.

Hereinafter, the principles of operation and embodiments of the disclosure will be described with reference to the accompanying drawings.

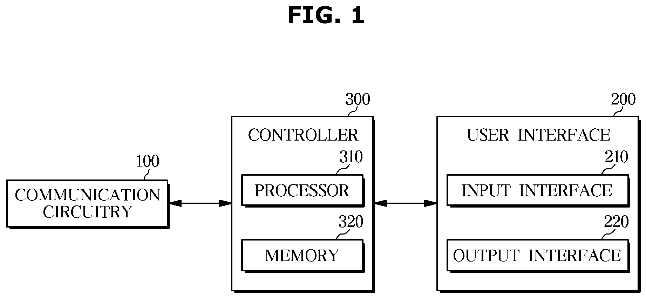

FIG. 1 is a control block diagram of an inspection apparatus 1 according to an embodiment.

Referring to FIG. 1, an inspection apparatus 1 according to the disclosure may include communication circuitry 100 communicating with a home appliance to be inspected, a user interface 200 receiving a user input or outputting information to a user, and a controller 300 performing a power consumption inspection of the home appliance based on the received user input.

Here, the home appliance includes a refrigeration cycle, and may include a refrigerator, an air conditioner, and a dryer.

The communication circuitry 100 may be connected to the home appliance by wire or wirelessly to communicate with the home appliance. The communication circuitry 100 may transmit a signal related to the operation of the home appliance to the home appliance, or may receive a power value of the home appliance.

The user interface 200 may include an input interface 210 obtaining a user command for the inspection apparatus 1, and an output interface 220 providing the user with a result of the power consumption inspection performed in the inspection apparatus 1.

The input interface 210 may include any type of user input devices including a microphone, a button, a switch, a touch screen, and/or a touch pad. The user may input commands for starting, stopping, resuming, and ending the inspection through the input interface 210.

The input interface 210 may be electrically connected to the controller 300, and the user command may be transmitted to the controller 300 through the input interface 210. The controller 300 may control the operation of the inspection apparatus 1 based on the user command.

The output interface 220 may be electrically connected to the controller 300, and may output information related to the operation of the inspection apparatus 1 under the control of the controller 300. For example, information about the state of the inspection, such as starting, stopping, resuming, and ending the inspection, may be output. In addition, the output interface 220 may output a result of the inspection performed in the inspection apparatus 1.

The output interface 220 may include a display and a speaker. The speaker may be an acoustic device that may output various sounds. The display may display information input by the user or information provided to the user as various graphic elements. For example, operation information of the inspection apparatus 1 may be displayed as at least one of an image or text. In addition, the display may include an indicator that provides specific information. The display may include a liquid crystal display (LCD) panel, a light emitting diode (LED) panel, an organic light emitting diode (OLED) panel, a micro LED panel, and/or a plurality of LEDs.

The controller 300 may include a processor 310 controlling the operation of the inspection apparatus 1, and a memory 320 storing programs and data for controlling the operation of the inspection apparatus 1.

The processor 310 may generate a control signal for controlling the operation of the inspection apparatus 1 based on instructions, applications, data, and/or programs stored in the memory 320. The processor 310 may include logic circuitry and arithmetic circuitry in hardware. The processor 310 may process data according to programs and/or instructions provided from the memory 320, and generate a control signal according to the processing result. The memory 320 and the processor 310 may be implemented as a single control circuit or a plurality of circuits.

The memory 320 may include a volatile memory 320, such as static random access memory (S-RAM) and dynamic random access memory (DRAM) for temporarily storing data. In addition, the memory 320 may include a non-volatile memory 320, such as read only memory (ROM), erasable programmable read only memory (EPROM), and electrically erasable programmable read only memory (EEPROM) for long-term data storage.

The inspection apparatus 1 according to the disclosure is for providing an inspection method for power consumption before shipment of a home appliance in a complete product state. Accordingly, in order to inspect the power consumption of the home appliance, a compressor included in the home appliance may be one that is operated for the first time in the state of a complete product.

In a case where the power consumption is inspected during the initial operation of the home appliance in its complete product state, the initial conditions of the complete product are the same during the process, and thus some of the factors that may affect the power consumption may be eliminated.

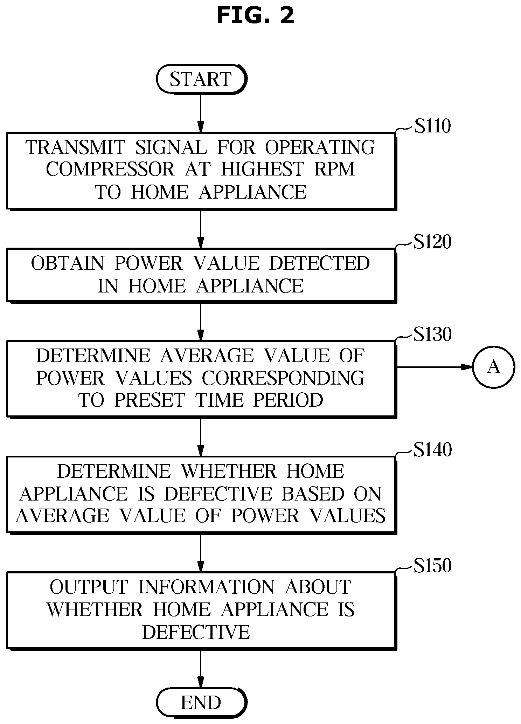

FIG. 2 is a flowchart illustrating a method for controlling the inspection apparatus 1 according to an embodiment.

Referring to FIG. 2, the controller 300 may transmit a signal for operating a compressor of a home appliance at a preset rotations per minute (RPM) to the home appliance (S110). Here, the preset RPM may be set to the highest RPM among RPMs at which the compressor is operable.

By operating the compressor at the highest RPM, characteristics of a refrigeration cycle may be maximized in a short time. Accordingly, the power-consumption inspection capability of the inspection apparatus 1 may increase.

Based on operation of the compressor of the home appliance, the controller 300 may obtain a power value detected in the home appliance from the home appliance (S120). The controller 300 may determine state information of the home appliance based on the obtained power value.

Here, the state information of the home appliance may include whether the home appliance is defective and a defective state of the home appliance. In addition, the defective state of the home appliance may include at least one state from among a compressor defect, presence of non-condensable gas, an excessive amount of refrigerant, internal piping blockage, or an insufficient amount of refrigerant.

In a case where the non-condensable gas is present (included) inside the compressor of the home appliance, a degree of vacuum is not maintained below a defined level, and thus an internal pressure of the compressor may increase. As a result, the power value detected in the home appliance may increase.

In addition, in a case where the amount of refrigerant included in the compressor of the home appliance is excessive compared to a normal amount, the internal pressure of the compressor may increase, and thus the power value detected in the home appliance may increase.

In addition, in a case where the amount of refrigerant included in the compressor of the home appliance is insufficient compared to the normal amount, the internal pressure of the compressor may decrease, and thus the power value detected in the home appliance may decrease.

In addition, in a case where blockage of the internal piping of the home appliance occurs, a circulation amount of refrigerant may decrease, the internal pressure of the compressor may decrease, and thus, the power value detected in the home appliance may decrease.

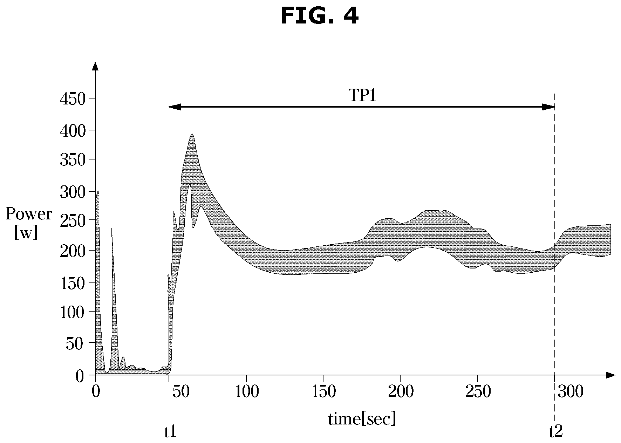

FIG. 4 is a graph illustrating power values detected in the home appliance over time according to an embodiment. The x-axis of FIG. 4 represents time (sec), and the y-axis represents the power value (w) detected in the home appliance.

Referring to FIG. 4, the controller 300 may obtain a power value detected in the home appliance over time.

The controller 300 may determine an average value of power values corresponding to a preset time TP1 among the power values obtained from the home appliance (S130). That is, the controller 300 may obtain a plurality of power values that change over time from the home appliance. In addition, the controller 300 may calculate an average value of the power values corresponding to the preset time TP1 among the obtained plurality of power values.

For example, as shown in FIG. 4, the controller 300 may set the preset time TP1 as a time period between a time point t1 and a time point t2. That is, the controller 300 may determine the average value of the power values corresponding to the preset time TP1 between the time point t1 and the time point t2.

An arbitrary time period is preset as a target time period for the average value calculation among the plurality of power values, because it is required to perform inspection for a limited time during the process of complete product.

The controller 300 may determine at least one of whether the home appliance is defective or a defective state of the home appliance based on the determined average value of the power values (S140). That is, because whether the home appliance is defective and the defective state of the home appliance may be determined within a limited time, an efficient inspection may be performed. In addition, due to the shortened inspection time, a total inspection may be performed instead of a sampling inspection, thereby securing product competitiveness.

The controller 300 may control the output interface 220 to provide a user with information about at least one of whether the home appliance is determined defective or the determined defective state (S150). That is, the output interface 220 may provide the user with at least one of information about whether the home appliance is determined defective or information about the determined defective state.

As such, according to the inspection apparatus 1 and the control method thereof according to the disclosure, power consumption may be easily inspected in a complete product rather than in component units before shipment of the product.

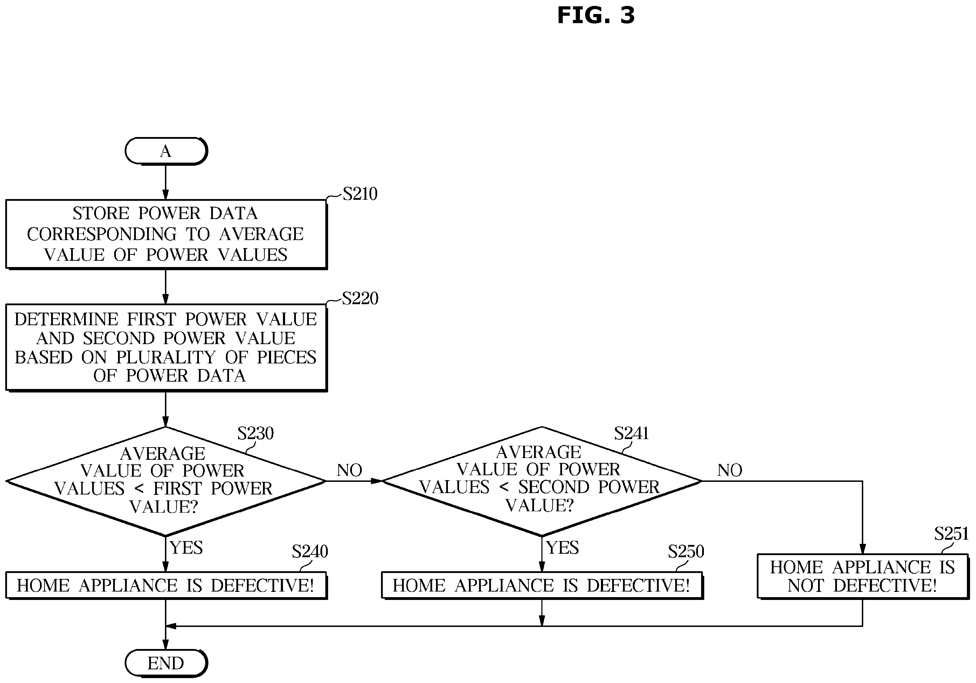

FIG. 3 illustrates a flowchart showing a control method of the inspection apparatus 1 according to an embodiment.

Referring to FIG. 3, the controller 300 may store power data corresponding to the average value of the power values determined in operation S130 of FIG. 2 in the memory 320 (S210). Because the inspection apparatus 1 according to the disclosure may be provided to perform an inspection before shipment of the product, a plurality of home appliances immediately may be inspected in large numbers before shipment.

Accordingly, the controller 300 may obtain a power value obtained during the preset time TP1 from each of the plurality of home appliances. In addition, the controller 300 may determine an average value of the power values for each of the plurality of home appliances. Accordingly, the controller 300 may store a plurality of pieces of power data indicating an average value of the power values corresponding to the preset time TP1 for each of the plurality of home appliances in the memory 320.

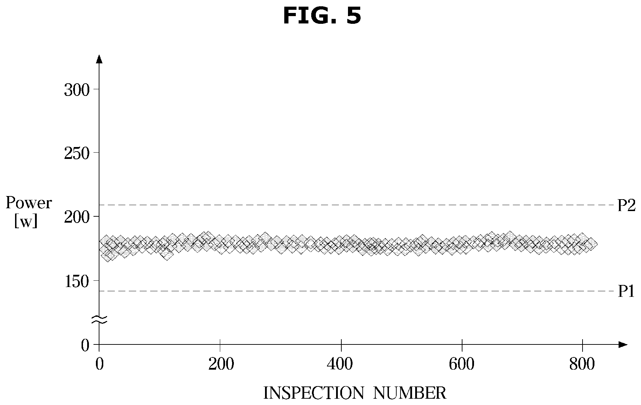

FIG. 5 is a graph illustrating an average value of power values corresponding to the preset time TP1 for each of a plurality of home appliances to be inspected according to an embodiment.

The x-axis of FIG. 5 represents an inspection number of each of the plurality of home appliances, and the y-axis represents an average value of the power values corresponding to the preset time TP1 among the power values detected in the home appliance.

Referring to FIG. 5, each of the plurality of dots shown in FIG. 5 represents the average value of the power values corresponding to the preset time TP1 for each of the plurality of home appliances. That is, as described above, by storing a plurality of pieces of power data for each of the plurality of home appliances in the memory 320, a database may be built for each model of the product to be shipped.

The controller 300 may determine a first power value P1 and a second power value P2 based on the plurality of pieces of power data (S220). For example, the controller 300 may determine, as the first power value P1, a result value obtained by adding a first ratio to the average value of the plurality of pieces of power data. In addition, the controller 300 may determine, as the second power value P2, a result value obtained by adding a second ratio to the average value of the plurality of pieces of power data. Accordingly, the second power value P2 may be greater than the first power value P1. Here, the first power value P1 may indicate a lower specification limit (LSL), and the second power value P2 may indicate an upper specification limit (USL).

The controller 300 may determine at least one of whether the home appliance is defective or a defective state of the home appliance, based on the average value of the power values corresponding to the preset time TP1 among the power values detected in the home appliance by using the first power value P1 and the second power value P2.

The controller 300 may determine whether the average value of the power values is less than the first power value P1 (S230). The controller 300 may determine that the home appliance is defective based on determining that the average value of the power values is less than the first power value P1 (S240). In addition, the controller 300 may determine that the defective state of the home appliance is in a state of at least one of the internal piping blockage or the insufficient amount of refrigerant based on determining that the average value of the power values is less than the first power value P1.

Meanwhile, the controller 300 may determine whether the average value of the power values is greater than the second power value P2 based on determining that the average value of the power values is greater than or equal to the first power value P1 (S241). The controller 300 may determine that the home appliance is defective based on determining that the average value of the power values is greater than the second power value P2 (S250). In addition, the controller 300 may determine that the defective state of the home appliance is in a state of at least one of the presence of non-condensable gas or the excessive amount of refrigerant based on determining that the average value of the power values is greater than the second power value P2.

The controller 300 may determine that the home appliance is not defective based on determining that the average value of the power values is greater than or equal to the first power value P1 and less than or equal to the second power value P2 (S251).

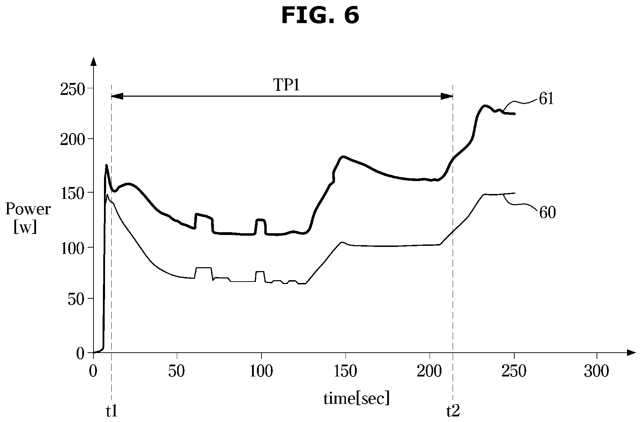

FIG. 6 is a graph comparing a power value detected in a defective home appliance and a power value detected in a non-defective home appliance according to an embodiment.

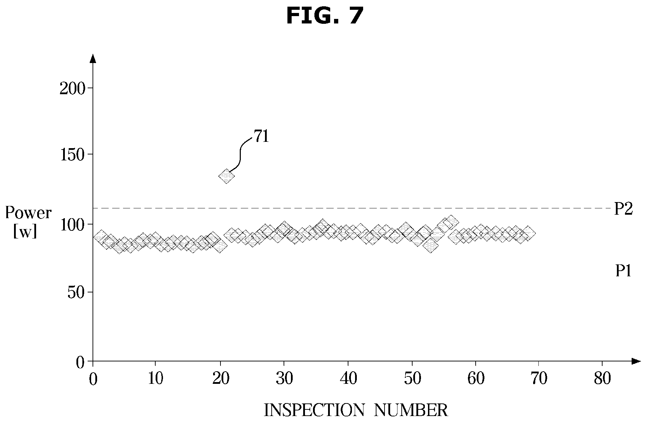

FIG. 7 is a graph illustrating an average value of power values corresponding to the preset time TP1 among power values detected in a defective home appliance according to an embodiment.

The x-axis of FIG. 6 represents time, and the y-axis represents the power value detected in the home appliance.

The x-axis of FIG. 7 represents an inspection number of each of the plurality of home appliances, and the y-axis represents the average value of the power values corresponding to the preset time TP1 among the power values detected in the home appliance.

Referring to FIG. 6 and FIG. 7, the controller 300 may set the preset time TP1 as a time period between a time point t1 and a time point t2. The controller 300 may determine the average value of the power values corresponding to the preset time TP1 among the power values detected in each of the plurality of home appliances.

Each of the plurality of dots shown in FIG. 7 represents the average value of the power values corresponding to the preset time TP1 for each of the plurality of home appliances.

For example, referring to a thin line 60 of FIG. 6 and FIG. 7, the average value of the y-axis values corresponding to the preset time TP1 among the y-axis values of the thin line 60 of FIG. 6 is greater than or equal to the first power value P1 and less than or equal to the second power value P2. Accordingly, the controller 300 may determine that the home appliance in which a power value corresponding to y-axis values of the thin line 60 of FIG. 6 is detected is not defective.

In addition, referring to a thick line 61 of FIG. 6 and FIG. 7, an average value 71 of the y-axis values corresponding to the preset time TP1 among the y-axis values of the thick line 61 of FIG. 6 is greater than the second power value P2. Accordingly, the controller 300 may determine that the home appliance in which a power value corresponding to y-axis values of the thick line 61 of FIG. 6 is detected is defective.

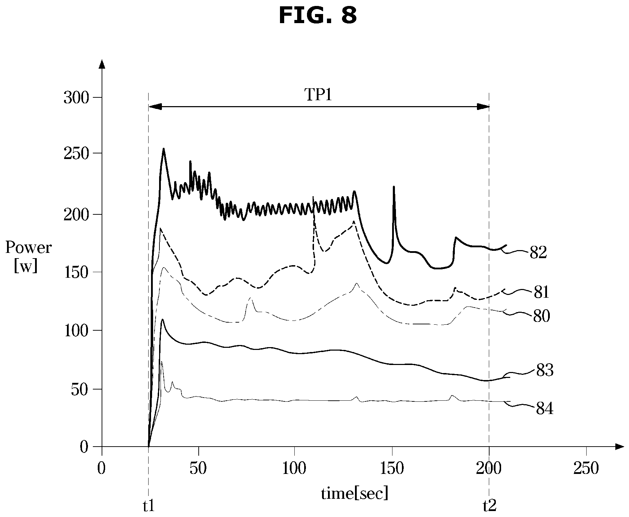

FIG. 8 is a graph comparing a power value detected in a defective home appliance and a power value detected in a non-defective home appliance according to an embodiment.

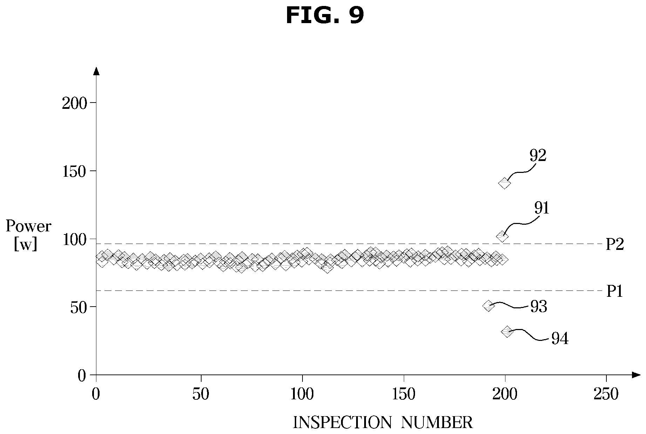

FIG. 9 is a graph illustrating an average value of power values corresponding to the preset time TP1 among power values detected in a defective home appliance according to an embodiment.

The x-axis of FIG. 8 represents time, and the y-axis represents the power value detected in the home appliance.

The x-axis of FIG. 9 represents an inspection number of each of the plurality of home appliances, and the y-axis represents the average value of the power values corresponding to the preset time TP1 among the power values detected in the home appliance.

Referring to FIG. 8 and FIG. 9, the controller 300 may set the preset time TP1 as a time period between the time point t1 and the time point t2. The controller 300 may determine the average value of the power values corresponding to the preset time TP1 among the power values detected in each of the plurality of home appliances.

Each of the plurality of dots shown in FIG. 9 represents the average value of the power values corresponding to the preset time TP1 for each of the plurality of home appliances. Among the plurality of dots, dots corresponding to y-axis values less than the first power value P1 or greater than the second power value P2 may be determined to be defective home appliances.

For example, referring to a first line 80 of FIG. 8 and FIG. 9, the average value of the y-axis values corresponding to the preset time TP1 among the y-axis values of the first line 80 of FIG. 8 is greater than or equal to the first power value P1 and less than or equal to the second power value P2. Accordingly, the controller 300 may determine that the home appliance in which a power value corresponding to y-axis values of the first line 80 of FIG. 8 is detected is not defective.

In addition, referring to a second line 81 of FIG. 8 and FIG. 9, an average value 91 of the y-axis values corresponding to the preset time TP1 among the y-axis values of the second line 81 of FIG. 8 is greater than the second power value P2. Accordingly, the controller 300 may determine that the home appliance in which a power value corresponding to y-axis values of the second line 81 of FIG. 8 is detected is defective. In addition, the controller 300 may determine that the home appliance in which a power value corresponding to y-axis values of the second line 81 of FIG. 8 is detected is in a state of at least one of the presence of non-condensable gas or the excessive amount of refrigerant.

In addition, referring to a third line 82 of FIG. 8 and FIG. 9, an average value 92 of the y-axis values corresponding to the preset time TP1 among the y-axis values of the third line 82 of FIG. 8 is greater than the second power value P2. Accordingly, the controller 300 may determine that the home appliance in which a power value corresponding to y-axis values of the third line 82 of FIG. 8 is detected is defective. In addition, the controller 300 may determine that the home appliance in which a power value corresponding to y-axis values of the third line 82 of FIG. 8 is detected is in a state of at least one of the presence of non-condensable gas or the excessive amount of refrigerant.

In addition, referring to a fourth line 83 of FIG. 8 and FIG. 9, an average value 93 of the y-axis values corresponding to the preset time TP1 among the y-axis values of the fourth line 83 of FIG. 8 is less than the first power value P1. Accordingly, the controller 300 may determine that the home appliance in which a power value corresponding to y-axis values of the fourth line 83 of FIG. 8 is detected is defective. In addition, the controller 300 may determine that the home appliance in which a power value corresponding to y-axis values of the fourth line 83 of FIG. 8 is detected is in a state of at least one of the internal piping blockage or the insufficient amount of refrigerant.

In addition, referring to a fifth line 84 of FIG. 8 and FIG. 9, an average value 94 of the y-axis values corresponding to the preset time TP1 among the y-axis values of the fifth line 84 of FIG. 8 is less than the first power value P1. Accordingly, the controller 300 may determine that the home appliance in which a power value corresponding to y-axis values of the fifth line 84 of FIG. 8 is detected is defective. In addition, the controller 300 may determine that the home appliance in which a power value corresponding to y-axis values of the fifth line 84 of FIG. 8 is detected is in a state of at least one of the internal piping blockage or the insufficient amount of refrigerant.

According to an aspect of the disclosure, whether a home appliance is defective and a defective state of the home appliance may be determined within a limited time, thereby enabling efficient power consumption inspection.

According to an aspect of the disclosure, a total inspection may be performed due to the shortened inspection time instead of a sampling inspection, thereby enhancing product competitiveness.

According to an aspect of the disclosure, characteristics of a refrigeration cycle may be maximized by driving a compressor at the highest RPM, thereby increasing power-consumption inspection capabilities.

According to an aspect of the disclosure, power consumption may be easily inspected in a complete product rather than in component units before shipment of the product.

According to an embodiment of the disclosure, in a method for controlling an inspection apparatus 1 configured to inspect power consumption of a home appliance including a compressor, the method may include: transmitting a signal for operating the compressor at a preset rotations per minute (RPM) to the home appliance; obtaining a power value detected in the home appliance from the home appliance; and determining whether the home appliance is defective based on power values obtained during a preset time TP1 among the obtained power values.

The determining of whether the home appliance is defective may include determining that the home appliance is defective, based on an average value of the power values obtained during the preset time TP1 being less than a defined first power value P1.

The determining of whether the home appliance is defective may include determining that the home appliance is defective, based on the average value of the power values obtained during the preset time TP1 being greater than a defined second power value P2 greater than the defined first power value P1.

The determining of whether the home appliance is defective may include determining that the home appliance is not defective, based on the average value of the power values obtained during the preset time TP1 being greater than or equal to the defined first power value P1 and less than or equal to the defined second power value P2.

The determining of whether the home appliance is defective may include determining that the home appliance is in a state of at least one of a compressor defect, presence of non-condensable gas, an excessive amount of refrigerant, internal piping blockage, or an insufficient amount of refrigerant based on the average value of the power values obtained during the preset time TP1.

The determining of whether the home appliance is defective may include determining that the home appliance is in a state of at least one of the internal piping blockage or the insufficient amount of refrigerant, based on the average value of the power values obtained during the preset time TP1 being less than the defined first power value P1.

The determining of whether the home appliance is defective may include determining that the home appliance is in a state of at least one of the presence of non-condensable gas or the excessive amount of refrigerant, based on the average value of the power values obtained during the preset time TP1 being greater than the defined second power value P2.

The method may further include storing a plurality of pieces of power data indicating average values of the power values obtained during the preset time TP1 of each of a plurality of home appliances in a memory 320, wherein the determining of whether the home appliance is defective may include determining a first power value P1 and a second power value P2 greater than the first power value P1 based on the stored plurality of pieces of power data.

The determining of whether the home appliance is defective may include determining that the home appliance is defective, based on the average value of the power values obtained during the preset time TP1 being less than the first power value P1 or greater than the second power value P2.

The method may further include providing a user with information about whether the home appliance is determined defective through a user interface 200.

According to an embodiment of the disclosure, an inspection apparatus 1 may include: communication circuitry 100 configured to communicate with a home appliance; a user interface 200 configured to receive a user input or output information to a user; and a controller 300 configured to perform a power consumption inspection of the home appliance based on the received user input, wherein the controller 300 may be configured to: transmit a signal for operating a compressor included in the home appliance at a preset rotations per minute (RPM) to the home appliance through communication circuitry 100; obtain a power value detected in the home appliance from the home appliance through the communication circuitry 100; and determine whether the home appliance is defective based on a power value corresponding to a preset time TP1 among the obtained power values.

The controller 300 may be configured to determine that the home appliance is defective, based on an average value of the power values obtained during the preset time TP1 being less than a defined first power value P1.

The controller 300 may be configured to determine that the home appliance is defective, based on the average value of the power values obtained during the preset time TP1 being greater than a defined second power value P2 greater than the defined first power value P1.

The controller 300 may be configured to determine that the home appliance is not defective, based on the average value of the power values obtained during the preset time TP1 being greater than or equal to the defined first power value P1 and less than or equal to the defined second power value P2, wherein the defined second power value P2 is greater than the defined first power value P1.

The controller 300 may be configured to determine that the home appliance is in a state of at least one of a compressor defect, presence of non-condensable gas, an excessive amount of refrigerant, internal piping blockage, or an insufficient amount of refrigerant based on the average value of the power values obtained during the preset time TP1.

The controller 300 may be configured to determine that the home appliance is in a state of at least one of the internal piping blockage or the insufficient amount of refrigerant, based on the average value of the power values obtained during the preset time TP1 being less than the defined first power value P1

The controller 300 may be configured to determine that the home appliance is in a state of at least one of the presence of non-condensable gas or the excessive amount of refrigerant, based on the average value of the power values obtained during the preset time TP1 being greater than the defined second power value P2.

The controller 300 may store a plurality of pieces of power data indicating average values of the power values obtained during the preset time TP1 of each of a plurality of home appliances in a memory 320 and determine a first power value P1 and a second power value P2 greater than the first power value P1 based on the stored plurality of pieces of power data.

The controller 300 may be configured to determine that the home appliance is defective, based on the average value of the power values obtained during the preset time TP1 being less than the first power value P1 or greater than the second power value P2.

The inspection apparatus 1 may further include a user interface 200 configured provide a user with information about whether the home appliance is determined defective.

Meanwhile, the disclosed embodiments may be implemented in the form of a recording medium that stores instructions executable by a computer. The instructions may be stored in the form of program codes, and when executed by a processor, the instructions may create a program module to perform operations of the disclosed embodiments. The recording medium may be implemented as a computer-readable recording medium.

The computer-readable recording medium may include all kinds of recording media storing instructions that may be interpreted by a computer. For example, the computer-readable recording medium may be read only memory (ROM), random access memory (RAM), a magnetic tape, a magnetic disc, a flash memory, an optical data storage device, etc.

Furthermore, the computer-readable recording medium may be provided in the form of a non-transitory storage medium. The term 'non-transitory storage medium' may refer to a tangible device without including a signal (e.g., electromagnetic waves) and may not distinguish between storing data in the storage medium semi-permanently and temporarily. For example, the non-transitory storage medium may include a buffer that temporarily stores data.

According to an embodiment, the method according to the various embodiments disclosed herein may be provided in a computer program product. The computer program product may be a commercial product that may be traded between a seller and a buyer. The computer program product may be distributed in the form of a storage medium (e.g., a compact disc read only memory (CD-ROM)), through an application store (e.g., Play Store^{™}), directly between two user devices (e.g., smart phones), or online (e.g., downloaded or uploaded). In the case of online distribution, at least part of the computer program product (e.g., a downloadable app) may be at least temporarily stored or arbitrarily created in a storage medium that may be readable to a device such as a server of the manufacturer, a server of the application store, or a relay server.

Although the embodiments of the disclosure have been described with reference to the accompanying drawings, those skilled in the art will appreciate that these inventive concepts may be embodied in different forms without departing from the scope and spirit of the disclosure, and should not be construed as limited to the embodiments set forth herein.

## Claims

1. A method for controlling an inspection apparatus (1) configured to inspect power consumption of a home appliance including a compressor, the method comprising:
transmitting a signal for operating the compressor at a preset rotations per minute (RPM) to the home appliance;
obtaining a power value detected in the home appliance from the home appliance; and
determining whether the home appliance is defective based on power values obtained during a preset time (TP1) among the obtained power values.

2. The method of claim 1, wherein the determining of whether the home appliance is defective comprises determining that the home appliance is defective, based on an average value of the power values obtained during the preset time (TP1) being less than a defined first power value (P1).

3. The method of claim 2, wherein the determining of whether the home appliance is defective comprises determining that the home appliance is defective, based on the average value of the power values obtained during the preset time (TP1) being greater than a defined second power value (P2) greater than the defined first power value (P1).

4. The method of claim 1, wherein the determining of whether the home appliance is defective comprises determining that the home appliance is not defective, based on an average value of the power values obtained during the preset time (TP1) being greater than or equal to a defined first power value (P1) and less than or equal to a defined second power value (P2).

5. The method of claim 1, wherein the determining of whether the home appliance is defective comprises determining that the home appliance is in a state of at least one of a compressor defect, presence of non-condensable gas, an excessive amount of refrigerant, internal piping blockage, or an insufficient amount of refrigerant based on an average value of the power values obtained during the preset time (TP1).

6. The method of claim 5, wherein the determining of whether the home appliance is defective comprises determining that the home appliance is in a state of at least one of the internal piping blockage or the insufficient amount of refrigerant, based on the average value of the power values obtained during the preset time (TP1) being less than a defined first power value (P1).

7. The method of claim 5, wherein the determining of whether the home appliance is defective comprises determining that the home appliance is in a state of at least one of the presence of non-condensable gas or the excessive amount of refrigerant, based on the average value of the power values obtained during the preset time (TP1) being greater than a defined second power value (P2).

8. The method of claim 1, further comprising:
storing a plurality of pieces of power data indicating average values of the power values obtained during the preset time (TP1) of each of a plurality of home appliances in a memory (320),
wherein the determining of whether the home appliance is defective comprises determining a first power value (P1) and a second power value (P2) greater than the first power value (P1) based on the stored plurality of pieces of power data.

9. The method of claim 8, wherein the determining of whether the home appliance is defective comprises determining that the home appliance is defective, based on the average value of the power values obtained during the preset time (TP1) being less than the first power value (P1) or greater than the second power value (P2).

10. The method of claim 1, further comprising:
providing a user with information about whether the home appliance is determined defective through a user interface (200).

11. An inspection apparatus (1), comprising:
communication circuitry (100) configured to communicate with a home appliance;
a user interface (200) configured to receive a user input or output information to a user; and
a controller (300) configured to perform a power consumption inspection of the home appliance based on the received user input,
wherein the controller (300) is configured to:
transmit a signal for operating a compressor included in the home appliance at a preset rotations per minute (RPM) to the home appliance through communication circuitry (100);
obtain a power value detected in the home appliance from the home appliance through the communication circuitry (100); and
determine whether the home appliance is defective based on a power value corresponding to a preset time (TP1) among the obtained power values.

12. The inspection apparatus (1) of claim 11, wherein the controller (300) is configured to determine that the home appliance is defective, based on an average value of the power values obtained during the preset time (TP1) being less than a defined first power value (P1).

13. The inspection apparatus (1) of claim 12, wherein the controller (300) is configured to determine that the home appliance is defective, based on the average value of the power values obtained during the preset time (TP1) being greater than a defined second power value (P2) greater than the defined first power value (P1).

14. The inspection apparatus (1) of claim 11, wherein the controller (300) is configured to determine that the home appliance is not defective, based on an average value of the power values obtained during the preset time (TP1) being greater than or equal to a defined first power value (P1) and less than or equal to a defined second power value (P2),
wherein the defined second power value (P2) is greater than a defined first power value (P1).

15. The inspection apparatus (1) of claim 11, wherein the controller (300) is configured to determine that the home appliance is in a state of at least one of a compressor defect, presence of non-condensable gas, an excessive amount of refrigerant, internal piping blockage, or an insufficient amount of refrigerant based on an average value of the power values obtained during the preset time (TP1).
